(19) Europäisches Patentamt
European Patent Office
Office européen des brevets

(11) **EP 1 860 600 A1**

(12) **EUROPEAN PATENT APPLICATION**

(43) Date of publication:
**28.11.2007 Bulletin 2007/48**

(51) Int Cl.:
***G06N 1/00*** *(2006.01)*

(21) Application number: **06114602.3**

(22) Date of filing: **26.05.2006**

| | |
|---|---|
| (84) Designated Contracting States: **AT BE BG CH CY CZ DE DK EE ES FI FR GB GR HU IE IS IT LI LT LU LV MC NL PL PT RO SE SI SK TR** Designated Extension States: **AL BA HR MK YU** | • **Williams, David** **Cambridge, Cambridgeshire CB1 2EB (GB)** (74) Representative: **Piotrowicz, Pawel Jan Andrzej et al** **Venner Shipley LLP** **Byron House** **Cambridge Business Park** **Cowley Road** **Cambridge CB4 0WZ (GB)** |
| (71) Applicant: **Hitachi Ltd.** **Tokyo (JP)** | |
| (72) Inventors: • **Andreev, Aleksey** **c/o Hitachi Cambridge Laboratory** **Cambridge, Cambridgeshire CB3 0HE (GB)** | |

(54) **Quantum dot device**

(57)     A quantum dot device (1) includes a first region (13, 14, 17) of silicon configured to provide a first double quantum dot (2), a second region (15, 16, 18) of silicon configured to provide a second coupled quantum dot (3) and a silicon bridge (19) between the first and second regions of silicon for coupling the first and second double quantum dots.

Fig. 1

EP 1 860 600 A1

**Description**

The present invention relates to a quantum dot device particularly, but not exclusively, for quantum computing.

A quantum dot is widely considered to be a promising basis for providing quantum bits or "qubits" in quantum computing.

EP-A-1262911 describes a device for quantum computing having a charge qubit defined by a double quantum dot. The double quantum dot is resistively coupled to source and drain leads which are used to prepare an initial state of the qubit. However, using resistively coupled leads has a drawback that the leads are significant sources of noise which contribute to the qubit losing coherence.

"Charge-qubit operation of an isolated double quantum dot" by J. Gorman, D. G. Hasko and D. A. Williams, Physical Review Letters, volume 95, page 090502 (2005) describes a device for quantum computing in which the charge qubit is defined by an isolated quantum dot. All operations, including preparing the initial state of the qubit, are carried out via capacitively-coupled elements. Electrically isolating the double quantum dot system helps to extend the coherence time of the system.

Qubits and groups of qubits can be arranged to form complex quantum computing circuits. A quantum computer having multiple charge qubits can be formed by arranging double quantum dots in an array, as described, for example, in EP-A-1262911 *ibid.*

It is important to be able to control coupling or interaction between qubits or groups of qubits.

Qubits can be coupled through a Coulomb interaction (also referred to as "dipole-dipole interaction" or "electrostatic interaction"), for example as described in EP-A-1262911 *ibid.* However, coupling using Coulomb interaction suffers at least two disadvantages. Firstly, Coulomb interaction can be a significant source of decoherence, analogous to electron-electron scattering. Secondly, to limit Coulomb interaction to a particular set of qubits, the qubits should be positioned away from other qubits. This can limit formation of complex quantum computing circuits.

Qubits can also be coupled through so-called "tunnelling coupling". For example, "Coherent manipulation of electronic states in a double quantum dot" by T. Hayashi, T. Fujisawa, H. D. Cheong, Y. H. Jeong, and Y. Hirayama, Physical Review Letters, volume 91, page 226804 (2003) describes a double quantum dot formed in a two-dimensional electron gas defined in an GaAs/AlGaAs heterostructure using surface gates in which the dots are connected via a controllable potential barrier.

Tunnelling coupling has limited applicability. For silicon-based devices, a potential barrier formed at the interface between silicon (Si) and silicon dioxide ($SiO_2$) is around 3 eV. Thus, to provide suitable coupling, a potential barrier must be narrow, i.e. a few atomic layers, thereby making coupled qubits difficult to fabricate. Furthermore, tunnelling coupling can be difficult to control.

The present invention seeks to provide an improved quantum dot device.

According to the present invention there is provided a multiple-quantum dot device comprising a first system for providing at least one quantum dot, a second system for providing at least one quantum dot and a bridge between the first and second systems for providing at least one zero- or one-dimensional state freely extending from the first system to the second system.

A state "freely extends" across a system if it does not penetrate through a potential barrier and so, from a classical (as opposed to quantum mechanical) viewpoint, an electron (or hole) occupying such a state is allowable across the whole system. In other words, the energy of the electron (or hole) is greater than the potential energy throughout the system.

Thus, the extended state may be used as a selectable channel through which charge can be re-distributed between the first and second systems.

The first system may be for providing a first quantum dot and the second system may be for providing a second quantum dot. The first system may be for defining a coupled quantum dot and the second system may be for defining a second coupled quantum dot. The first system may be for defining a plurality of quantum dots and the second system may be for defining a plurality of quantum dots.

The bridge may be suitable for providing a quantum dot.

The bridge may provide a tunnel barrier to at least some states lying below a Fermi level in the first system.

The first system may comprise a first semiconductor region and the second system may comprise a second semiconductor region. The bridge may comprise a third semiconductor region. The regions may be provided in a layer of semiconductor material, such as silicon. The semiconductor regions may be doped with an impurity, preferably to a concentration greater than $1 \times 10^{19} \text{cm}^{-3}$.

The device may further comprise at least one electrometer for detecting charge in the first system. The device may further comprise at least one gate for applying an electric field to at least part of the first system.

The device may comprise an elongate bar of semiconductor material of thickness less than 50 nm, the elongate bar having alternating wide and narrow sections, the wide sections being less than 30 nm wide and the narrow sections being less than 10 nm wide. The elongate bar of semiconductor material may be of thickness less than 30 nm. The wide sections may be between 10 and 30 nm wide and the narrow sections may be between 1 and 10 nm wide.

According to a second aspect of the present invention there is provided a multiple-quantum dot device comprising an elongate bar of semiconductor material of thickness less than 50 nm, the elongate bar having alternating wide and narrow sections, the wide sections being less than 30 nm long and less than 30 nm wide and the narrow sections being less than 10 nm long and less than 10 nm wide, the elongate bar including first and second wide sections connected by a first narrow section for defining a first double quantum dot and third and fourth wide sections connected by a second narrow section for defining a second double quantum dot, wherein the second and third wide sections are connected by a third narrow section for coupling the first and second quantum dots.

The semiconductor may be silicon.

The device may be suitable for quantum computing.

According to a third aspect of the present invention there is provided apparatus comprising a multiple quantum dot device and a refrigerator arranged to cool the device.

The refrigerator may be arranged to cool the device to or below 77 Kelvin, preferably to or below 4.2 Kelvin. The refrigerator may be suitable for cooling the device to a temperature of the order of 1 or 10 milliKelvin.

The device may comprise a gate for applying an electric field to at least part of the first system and the apparatus further comprises circuitry configured to selectively apply a signal to the gate for applying an electric field to at least part of the first system so as to cause charge redistribution between the first and second system.

According to a fourth aspect of the present invention there is provided a method of fabricating a multiple-quantum dot device, the method comprising providing a first system for providing at least one quantum dot, providing a second system for providing at least one quantum dot and providing a bridge between the first and second systems for providing at least one zero- or one-dimensional state freely extending from the first system to the second system.

According to a fifth aspect of the present invention there is provided a method of operating a multiple-quantum dot device comprising a first system for providing at least one quantum dot, a second system for providing at least one quantum dot and a bridge between the first and second systems for providing at least one zero- or one-dimensional state freely extending from the first system to the second system, the method comprising applying an applying an electric field to at least part of the first system so as to cause charge redistribution between the first and second system.

Embodiments of the present invention will now be described by way of example, with reference to the accompanying drawings in which:

Figure 1 is a plan view of a first embodiment of a quantum dot device according to the present invention;
Figure 2 is a cross section of the device shown in Figure 1 taken along the line A-A';
Figure 3 is a plan view of a part of the device shown in Figure 1 providing two coupled qubits;
Figure 4a is a schematic diagram of energy levels in a first example of an isolated double quantum dot system;
Figure 4b is a schematic diagram of energy levels in a second example of an isolated double quantum dot system;
Figures 5a and 5b are schematic diagrams of energy levels of the device shown in Figure 1 with and without an applied electric field;
Figures 6a and 6b are schematic diagrams of energy levels of the device shown in Figure 1 in first and second degrees of detail;
Figures 7a and 7b are schematic diagrams of energy levels of a modified device in first and second degrees of detail;
Figures 8a and 8b are schematic diagrams of energy levels of another modified device in first and second degrees of detail;
Figure 9 shows the device shown in Figure 1, together with control and measurement circuitry;
Figure 10 illustrates a method of operating the device shown in Figure 1;
Figures 11a to 11d illustrate steps during fabrication of the device shown in Figure 1;
Figure 12 is a plan view of a second embodiment of a quantum dot device according to the present invention;
Figure 13 is a cross section of the device shown in Figure 12 taken along the line B-B';
Figure 14 is a plan view of a third embodiment of a device according to the present invention;
Figure 15 is a plan view of part of a fourth embodiment of a device according to the present invention which provides three coupled qubits;
Figure 16 is a schematic diagram of a computer model of the quantum dot device shown in Figure 1;
Figure 17 is a plot of computed values of a degree of coupling between pairs of quantum dots for the model shown in Figure 16 over a first energy range; and
Figure 18 is a plot of computed values of a degree of coupling between pairs of quantum dots for the model shown in Figure 16 over a second energy range.

*Device layout*

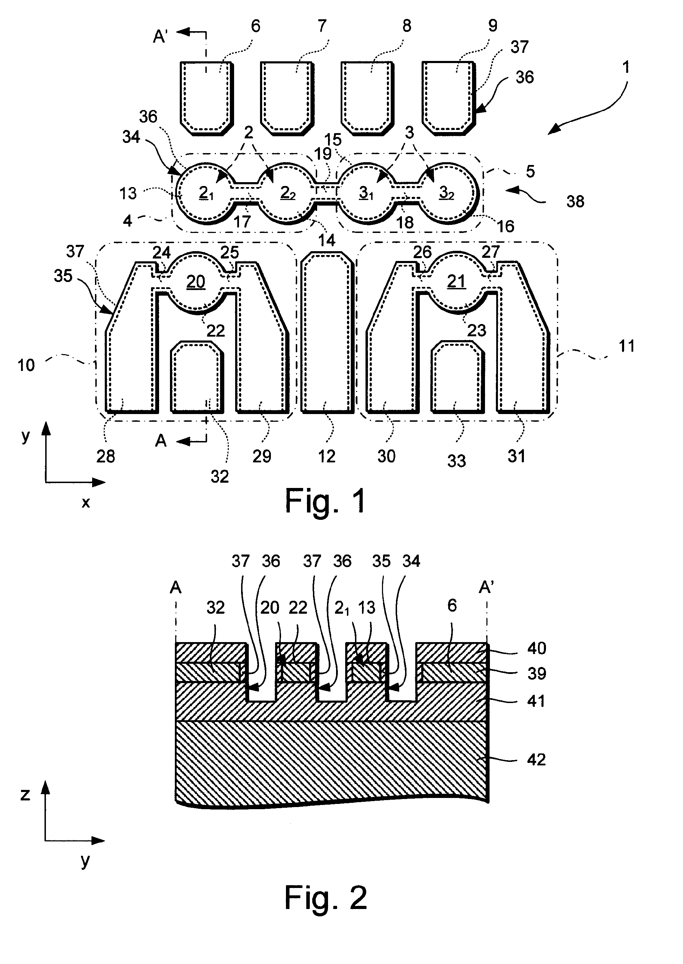

Referring to Figures 1 and 2, a first embodiment of a quantum dot device 1 according to the present invention is shown.

The device 1 is formed by trench-isolation and includes first and second double quantum dots 2, 3 for defining first and second qubits 4, 5 respectively. As will be explained in more detail later, basis states can be defined for each qubit 4, 5 according to whether an excess charge carrier is located on a first quantum dot $2_1$, $3_1$, in this example the left-hand quantum dot $2_1$, $3_1$, or on a second quantum dot $2_2$, $3_2$, in this case the right-hand quantum dot $2_2$, $3_2$.

The device 1 includes gates 6, 7, 8, 9 for applying respective electric fields to the quantum dots $2_1$, $2_2$, $3_1$, $3_2$ so as to adjust electrochemical potentials thereof. The gates 6, 7, 8, 9 are arranged as side gates for applying electric fields laterally to the quantum dots $2_1$, $2_2$, $3_1$, $3_2$.

The device 1 also includes first and second electrometers, in the form of single-electron transistors 10, 11, for measuring charge on the left-hand quantum dot $2_1$ of the first double quantum dot 2 and on the right-hand quantum dot $3_2$ of the second double quantum dot 3 respectively.

The device 1 also includes an additional side gate 12 for applying an electric field to the double quantum dots 2, 3 so as to adjust electrochemical potentials thereof. The additional gate 12 can be used to compensate for cross talk between the first double quantum dot 2 and the second single-electron transistor 11 and between the second double quantum dot 3 and the first single-electron transistor 10.

The double quantum dots 2, 3 are formed in first, second, third and fourth regions 13, 14, 15, 16 of n-type polycrystalline silicon. For each double quantum dot 2, 3, a coupling region 17, 18 connects two n-type polycrystalline regions 13, 14, 15, 16, thereby forming a system for providing a double quantum dot 2, 3. For example, a first coupling region 17 connects the first and second n-type polycrystalline regions 13, 14 and a second coupling region 18 connects the third and fourth n-type polycrystalline regions 15, 16.

The coupling regions 17, 18 are formed in respective regions of n-type polycrystalline silicon. As will be explained in more detail later, the coupling regions 17, 18 are sufficiently wide that they are not fully depleted and so provide conductive bridges. Thus, no tunnel barrier or only a short (i.e. not high) tunnel barrier is formed. However, the coupling regions 17, 18 are still sufficiently narrow and short for lateral confinement and, thus, formation of at least one quantised state which extends from the first n-type polycrystalline region 13 to the second n-type polycrystalline region 14 and at least one quantised state which extends from the third n-type polycrystalline region 15 to the fourth n-type polycrystalline region 16. Under these circumstances, the coupling regions 17, 18 couple the n-type polycrystalline regions 13, 14, 15, 16 through a first type of coupling, which is referred to herein as bridge coupling. Each coupling region 17, 18 is herein also referred to as a "bridge".

As will be explained in more detail later, the coupling regions 17, 18 may be sufficiently constricted that surface charge deplete these regions 17, 18, thereby forming tunnel barriers. Thus, the coupling regions 17, 18 couple the n-type polycrystalline regions 13, 14, 15, 16 through a second type of coupling, namely tunnel barrier coupling.

Another, third coupling region 19 also couples the double quantum dots 2, 3 such that the quantum dots $2_1$, $2_2$, $3_1$, $3_2$ form a chain. The third coupling region 19 is formed in n-type polycrystalline silicon and is arranged to couple the double quantum dots 2, 3 through bridge coupling.

Each single-electron transistors 10, 11 includes a quantum dot 20, 21 formed in corresponding regions 22, 23 of n-type polycrystalline silicon separated by constrictions 24, 25, 26, 27 from leads 28, 29, 30, 31. The constrictions 24, 25, 26, 27 are depleted of charge carriers and provide tunnel barriers. Each single-electron transistors 10, 11 also includes a gate 32, 33 for applying an electric field so as to adjust an electrochemical potential of the quantum dot 20, 21.

Conductive regions of the device 1 are laterally defined by etched sidewalls 34, 35 and flanking regions of silicon dioxide 36, 37. The quantum dot forming regions 13, 14, 15, 16 and coupling regions 17, 18, 19 are bounded by a region 36 of silicon dioxide running along etched sidewall 34 which defines a mesa 38. Likewise, the quantum dot forming regions 20, 21, constrictions 24, 25, 26, 27, gates 6, 7, 8, 9, 12, 32, 33 and leads 28, 29, 30, 31 are bounded by silicon dioxide regions 37 running along etched sidewalls 35.

Referring in particular to Figure 2, the regions 13, 14, 15, 16, 22, 23 forming the quantum dots, coupling regions 17, 18, 19, constrictions 24, 25, 26, 27, gates 6, 7, 8, 9, 12, 32, 33 and leads 28, 29, 30, 31 are formed in an etched layer 39 of n-type polycrystalline silicon having a thickness of 35 nm. The part of the etched layer 39 providing the regions 13, 14, 15, 16, 22, 23 forming the quantum dots and the coupling regions 17, 18, 19 is referred to as a bar. The n-type polycrystalline silicon layer 39 is protected by an etched capping layer 40 of silicon dioxide having a thickness of 20 nm and overlies a partially etched isolation layer 41 of silicon dioxide having a thickness of 400 nm and a thickness of about 300 nm in partially etched region. The layers 39, 40, 41 are provided on a silicon substrate 42.

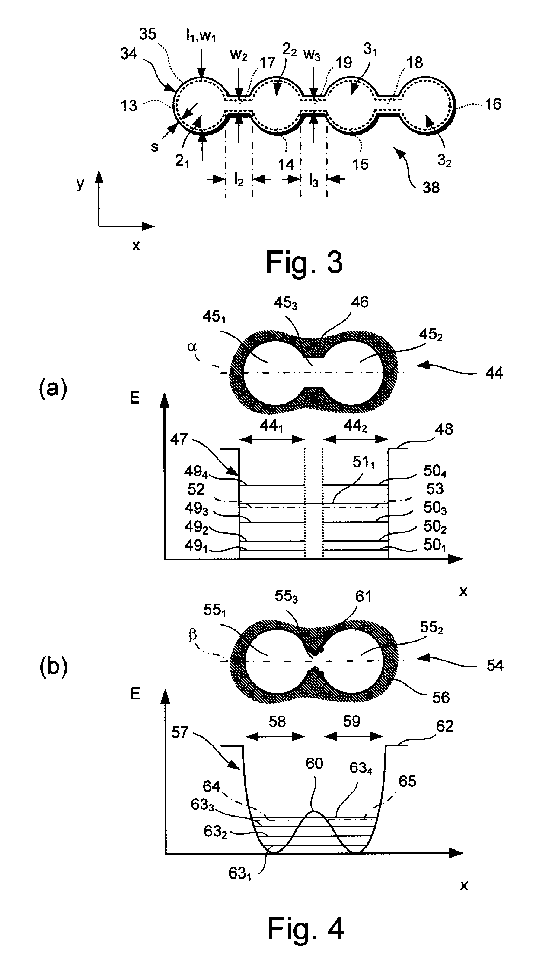

Referring to Figure 3, the mesa 38 is generally elongate and includes relatively wide sections of silicon for defining the quantum dots $2_1$, $2_2$, $3_1$, $3_2$ having a width, $w_1$, and length, $1_1$, of about 25 nm and relatively narrow sections of silicon for defining the first and second coupling regions 17, 18 having a width $w_2$ of about 5 nm and a length $l_2$ of about 5 nm. The mesa 38 also includes a narrow section for defining the third coupling region 19 having a width $w_3$ of about 5 nm and a length $1_3$ of about 5 nm. The silicon dioxide region 37 has a thickness, s, of about 3 nm.

The geometry and dimensions of the mesa 38 can be varied. In particular, the lengths and widths of the coupling regions 17, 18, 19 can be varied to alter the type of coupling, as will now be described.

*Coupling regions*

Referring to Figure 4a, a first example of an isolated double quantum dot system 44 includes first and second laterally-confined regions $45_1$, $45_2$ of semiconductor material, such as n-type polycrystalline silicon, joined by a third laterally-confined region $45_3$ of the semiconductor material. The semiconductor regions $45_1$, $45_2$, $45_3$ are bounded by a region 46 of insulating material, such as silicon dioxide. The semiconductor material regions $45_1$, $45_2$, $45_3$ are formed in a vertically-confined layer of the semiconductor material. The semiconductor regions $45_1$, $45_2$, $45_3$ are sufficiently confined for energy quantisation to occur, for example confined to dimensions of the order of 1 or 10 nm.

Lateral confinement causes formation of a flat-bottomed finite potential well 47 in the conduction band edge 48 and valence band edge (not shown). The illustrated conduction band edge profile is taken along an axis $\alpha$ passing through the middle of all three semiconductor regions $45_1$, $45_2$, $45_3$.

Vertical and lateral confinement causes a continuous energy spectrum, E, for electrons (and holes) to be broken into energy sub-bands, $E_{n, m, p}$. For example, a first set of quantised energy states $49_1$, $49_2$, $49_3$, $49_4$ associated with the first semiconductor region $45_1$ is formed in the finite potential well 47. Likewise, a second set of quantised energy states $50_1$, $50_2$, $50_3$, $50_4$ associated with the second semiconductor region $45_2$ is formed. A third set of quantised energy states $51_1$ associated with the third semiconductor region $45_3$ is also formed.

The first and second sets of quantised energy states $49_1$, $49_2$, $49_3$, $49_4$, $50_1$, $50_2$, $50_3$, $50_4$ are generally more closely spaced than the third set of quantised energy states $51_1$ because the first and second semiconductor regions $45_1$, $45_2$ are less confined than the third semiconductor region $45_3$.

Generally, the first and second sets of quantised energy states $49_1$, $49_2$, $49_3$, $49_4$, $50_1$, $50_2$, $50_3$, $50_4$ are localised to the first and second semiconductor regions $45_1$, $45_2$. However, at least some of the third set of quantised energy states $51_1$ freely extend over the first, second and third regions $45_1$, $45_2$, $45_3$. If the energies of the Fermi levels 52, 53 in the first and second semiconductor regions $45_1$, $45_2$ fall below the energy of a lowest extended energy state $51_1$, then electrons (not shown) occupying lower lying states $49_1$, $49_2$, $49_3$, $50_1$, $50_2$, $50_3$ cannot tunnel between the first and second semiconductor regions $45_1$, $45_2$.

In the first isolated double quantum dot system 44, the quantum dots $44_1$, $44_2$ are coupled by virtue of a bridge of semiconducting material which provides one or more channels for coupling the quantum dots $44_1$, $44_2$ at well-defined energies. The double quantum dot system 44 is analogous to a molecule.

Referring to Figure 4b, a second example of an isolated double quantum dot system 54 includes first and second laterally-confined regions $55_1$, $55_2$ of semiconductor material, such as n-type polycrystalline silicon, joined by a third laterally-confined region $55_3$ of the semiconductor material. The semiconductor regions $55_1$, $55_2$, $55_3$ are bounded by a region 56 of insulating material, such as silicon dioxide. The semiconductor material regions $55_1$, $55_2$, $55_3$ are formed in a vertically-confined layer of the semiconductor material. The semiconductor regions $55_1$, $55_2$, $55_3$ are sufficiently confined for energy quantisation to occur, for example having dimensions of the order of 1 or 10 nm.

The third semiconductor region $55_3$ is pinched more narrowly than the third semiconductor region $45_3$ of the first isolated double quantum dot system 44 (Figure 4a) described earlier. In this case, however, lateral confinement causes formation of a double potential well 57 having first and second wells 58, 59, separated by a tunnel barrier 60. The tunnel barrier 60 arises as a result of surface charge 61 located at the interface between the semiconductor regions $55_1$, $55_2$, $55_3$ and the insulating region 56. The proximity of the surface charge 61 either side of a narrow semiconductor region $55_3$ causes the conduction band edge 62 to bend, thus forming the tunnel barrier 60. A set of extended quantised energy states $63_1$, $63_2$, $63_3$, $63_4$ is formed across the two wells 58, 59. However, these states $63_1$, $63_2$, $63_3$, $63_4$ do not freely extend between the two wells 58, 59 because, from a classical viewpoint, electrons can only be located in the wells 58, 59 and not within the barrier 60.

The tunnel barrier 60 need not be formed by pinching the third semiconductor region $55_3$. Other arrangements can additionally or alternatively be used, such as by using lower doping concentration and/or by introducing additional surface charge. Additional surface charge can be introduced by choosing a material (such as gallium arsenide) which exhibits a higher concentration of surface charge at interfaces or by introducing damage at or close to the interface, for example by using reactive ion etching or ion implantation.

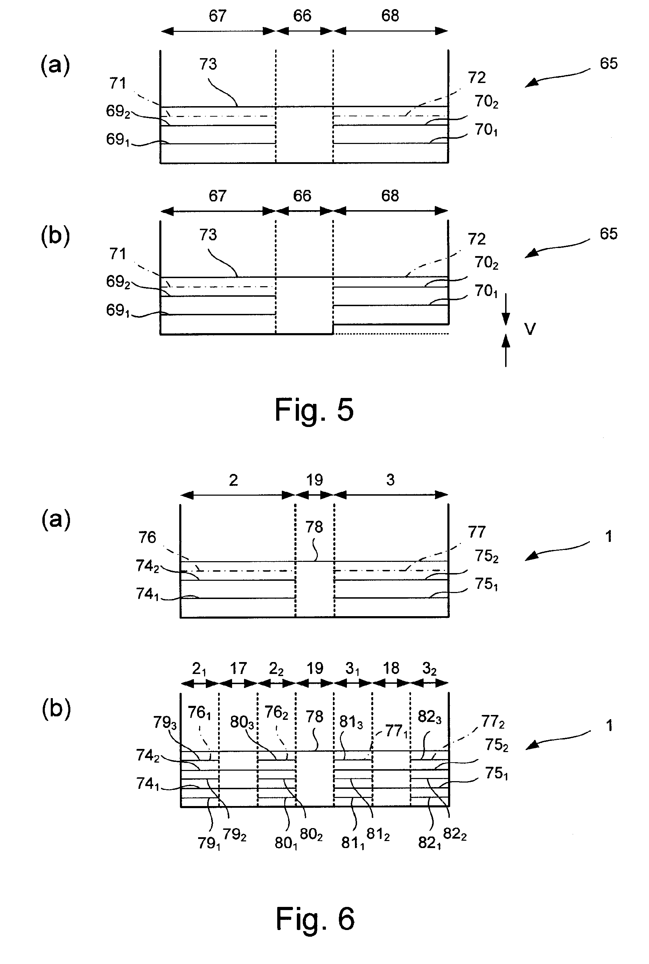

Referring to Figure 5a, a first example of generalised quantum dot system 65 which uses bridge coupling is shown. The system 65 includes a bridge 66 for coupling first and second systems 67, 68, each having a respective set of localised states $69_1$, $69_2$, $70_1$, $70_2$ and respective Fermi levels 71, 72. The bridge 66 may couple the two systems 67, 68 through an extended state 73. The system 65 is arranged, for example by providing a sufficiently low electron concentration and/or a sufficiently narrow bridge, such that the Fermi energies 71, 72 fall below the energy of the extended state 73.

When no external electric fields are applied, the two systems 67, 68 are decoupled. Thus, a highest-level electron is localised to one of the systems 67, 68.

Referring to Figure 5b, if an external electric field is applied to the second system 68 so as to raise the Fermi level 72 until it reaches the level of the extended state 73, then the two systems 67, 68 become coupled. The energy of the extended state 73 does not change or, if it does change, it does so by a smaller amount. An electron at the Fermi level 72 in second system 68 can be transferred through the extended state 73 to the first system 67.

Thus, external electric fields can be used to selectively couple (also referred to herein as "to bring to a working point") the first and second systems 67, 68. Thus, the probability of finding a highest-level electron in both systems 67, 68 is non-zero.

As will be explained later, the two systems 67, 68 can be qubits 4, 5 (Figure 1). When the qubits 4, 5 (Figure 1) are decoupled, they can be independently measured. When they are coupled, then the qubits 4, 5 (Figure 1) can interact.

Referring also to Figure 6a, the energy states of the device 1 may be described in terms of the generalised system 65. Thus, the device 1 includes a bridge 19 for coupling first and second double quantum dots 2, 3 having a first and second respective sets of states $74_1$, $74_2$, $75_1$, $75_2$ and respective Fermi levels 76, 77. The bridge 19 couples the first and second double quantum dots 2, 3 through an extended state 78.

Referring also to Figure 6b, a more detailed view of energy states of the device 1 is shown.

The first double quantum dot 2 includes the first region 17 for coupling the first and second quantum dots $2_1$, $2_2$. The first and second quantum dots $2_1$, $2_2$ have respective sets of states $79_1$, $79_2$, $79_3$, $80_1$, $80_2$, $80_3$ and respective Fermi levels $76_1$, $76_2$. The first region 17 couples the first and second quantum dots $2_1$, $2_2$ through the states $74_1$, $74_2$ which extend over the first double quantum dot 2, i.e. through bridge coupling.

The second double quantum dot 3 includes the second region 18 for coupling the first and second quantum dots $3_1$, $3_2$. The first and second quantum dots $3_1$, $3_2$ have respective sets of states $81_1$, $81_2$, $81_3$, $82_1$, $82_2$, $82_3$ and respective Fermi levels $77_1$, $77_2$. The second region 18 couples the first and second quantum dots $3_1$, $3_2$ through the states $75_1$, $75_2$ which extend over the second double quantum dot 3, i.e. through bridge coupling.

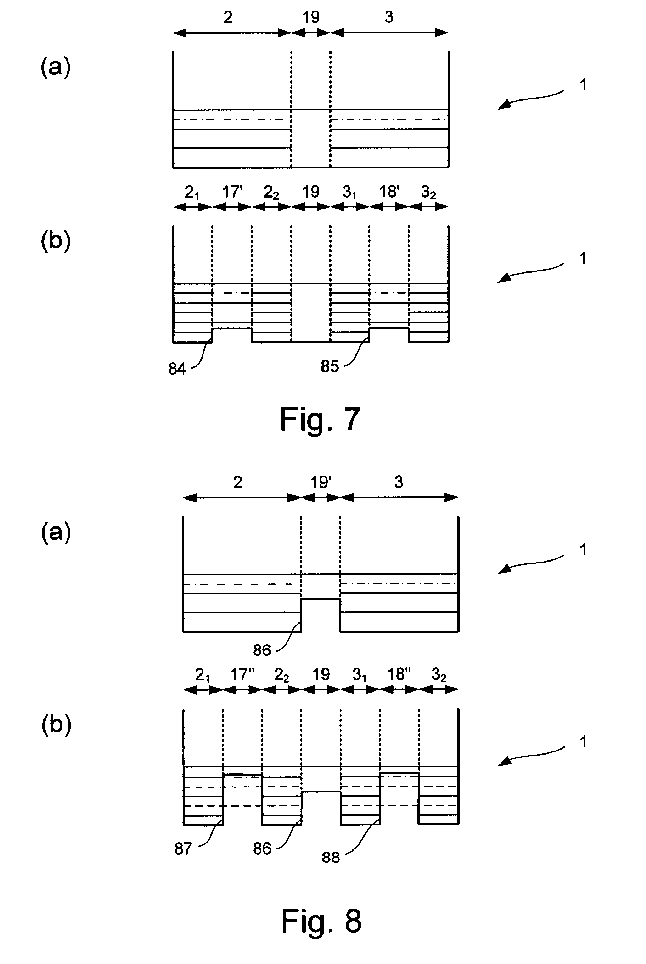

Referring to Figures 7a and 7b, the device 1 may be modified such that the quantum dots $2_1$, $2_2$, $3_1$, $3_2$ in each double quantum dot 2, 3 are coupled by a mixture of bridge and tunnel coupling. Thus, the first and second coupling regions 17', 18' may provide respective tunnel barriers 84, 85. The tunnel barriers 84, 85 are illustrated in Figure 7b as rectangular barriers for convenience. However, the potential profile of the tunnel barriers 84, 85 vary smoothly having at least one local maximum.

Referring to Figures 8a and 8b, the device 1 may be modified such that the double quantum dots 2, 3 are coupled by a mixture of bridge and tunnel coupling. Thus, the third coupling regions 19' may provide a tunnel barrier 86.

Furthermore, the device 1 may be modified such that the quantum dots $2_1$, $2_2$, $3_1$, $3_2$ in each double quantum dot 2, 3 are coupled by tunnel coupling. For example, the first and second coupling regions 17", 18" may provide respective tunnel barriers 87, 88.

*Device operation*

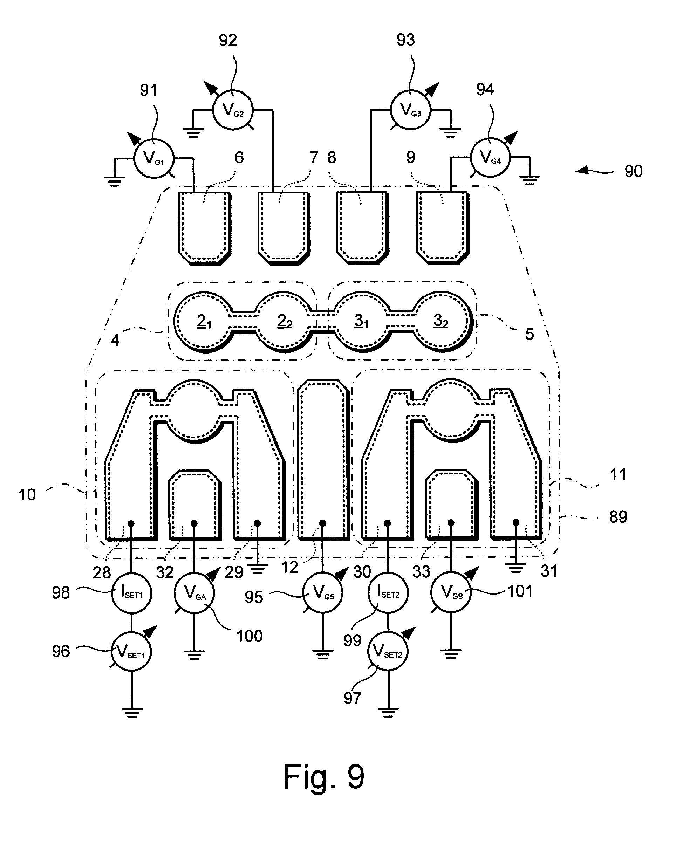

Referring to Figure 9, the device 1 is placed in a dilution refrigerator 89 for cooling the device 1 in manner well-known *per se.* In this example, the device 1 is cooled to 20 mK. However, other forms of refrigerator may be used and the device may be cooled to a temperature T such that adjacent energy states close to the Fermi level in the device 1 are well defined, i.e. separated by an amount $\Delta E$ such that $\Delta E \gg k_B T$, where $k_B$ is Boltzmann's constant and T is temperature.

The device 1 is coupled to control and measurement circuitry 90 which includes voltage sources 91, 92, 93, 94, 95 for applying biases to gates 6, 7, 8, 9, 12, voltage sources 96, 97 for applying biases across single-electron transistors 10, 11, current measurement devices 98, 99 for measuring current through the single-electron transistors 10, 11 and voltage sources 100, 101 for applying biases to the gates 32, 33 of the single-electron transistors 10, 11.

The double quantum dots 2, 3 each provide a two-state system based on the electron having the highest occupation level. Basis states for the first double quantum dot 2 and second double quantum dot 3 may be defined as follows:

$|0\rangle \equiv$ |excess electron on the left-hand quantum dot $2_1$, $3_1\rangle$
$|1\rangle \equiv$ |excess electron on the right-hand quantum dot $2_2$, $3_2\rangle$

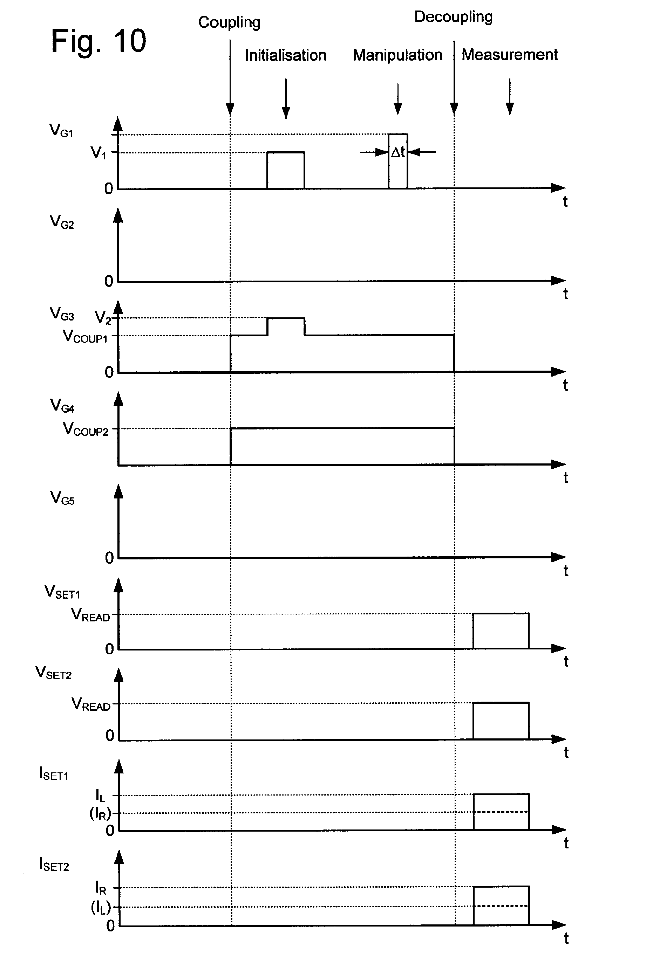

Referring to Figures 9 and 10, an example of a process by which the two qubits can be prepared, manipulated and measured will now be described.

If the qubits 4, 5 are coupled following a previous operation, they can be decoupled from each other before starting a new operation. To achieve decoupling, the gates 6, 7, 8, 9, 12 may be allowed to float or be grounded.

Coupling

The qubits 4, 5 are coupled by gate voltage sources 93, 94 applying coupling biases $V_{coup1}$, $V_{coup2}$ to the gates 8, 9 controlling the second double quantum dot 3. Thus, the qubits 4, 5 are brought to a working point (also known as "zero point").

A working point can be found by routine experiment. For example, values for $V_{coup1}$, $V_{coup2}$ may be increased, for example in steps of 1 mV. For a given set of values of $V_{coup1}$, $V_{coup2}$, a value for $V_{SET2}$ is set to a typical value for observing Coulomb blockade oscillations in the single-electron transistor 11 (typically of the order of 10 or 100 mV). The gate bias $V_{GB}$ applied to the single-electron transistor gate 33 is varied, for example over a range of a few volts. The working point is the set of values of $V_{coup1}$, $V_{coup2}$ which result in strong, preferably the strongest, Coulomb blockade oscillations.

Once the qubits 4, 5 are coupled, the states of the qubits 4, 5 can be prepared (or "initialised").

Initialization

An initial state $|\psi_i\rangle$, for example $|\psi_i\rangle = |0\rangle$, is prepared for each qubit 4, 5.

The first qubit 4 is prepared by the first gate voltage source 91 applying a bias $V_1$ to the first gate 6. The bias $V_1$ lowers the potential of the left-hand quantum dot $2_1$, thereby ensuring that the highest occupied level in the left-hand quantum dot $2_1$ is higher than highest occupied level in the right-hand quantum dot $2_2$.

Likewise, the second qubit 5 is prepared by the third gate voltage source 93 applying a bias $V_2$ to the third gate 8.

The first and third gate voltage sources 91, 93 remove the bias $V_1$, $V_2$, thereby leaving the qubits 4, 5 in an initial state $|0\rangle$.

It will be appreciated that other initial states may be prepared.

Manipulation

The coupled qubits 4, 5 can be manipulated, for example, by the first gate voltage source 91 applying a short pulse having a duration approximately $\Delta t = 5$ ns. The duration of the pulse may be varied to achieve the required result of manipulation.

This can be found by routine experiment, for example as described in EP-A-1262911 *ibid.*.

Decoupling

The gate voltage sources 93, 94 remove coupling biases $V_{coup\ 1}$, $V_{coup2}$.

Measurement

A final state $|\psi_f\rangle$ of each qubit 4, 5 is measured.

For the first single electron transistor 10, the gate voltage source 100 applies a gate bias to set an operating point. The operating point can be found by routine experiment, for example by preparing the first qubit 4 in an initial state $|\psi_i\rangle = |0\rangle$, so that an electron is located on the left-hand quantum dot $2_1$ (Figure 1), applying a "read" bias across leads 28, 29 and adjusting the gate bias applied to gate 32 until a maximum current is obtained.

The voltage source 96 applies a "read" bias across the leads 28, 29 and the current detector 98 measures current magnitude to determine charge distribution on the first qubit 4.

Likewise, for the second single electron transistor 11, the gate voltage source 101 applies a gate bias to set an operating point. The voltage source 97 applies a "read" bias across the leads 30, 31 and the current detector 99 measures current magnitude to determine charge distribution on the second qubit 5.

*Device fabrication*

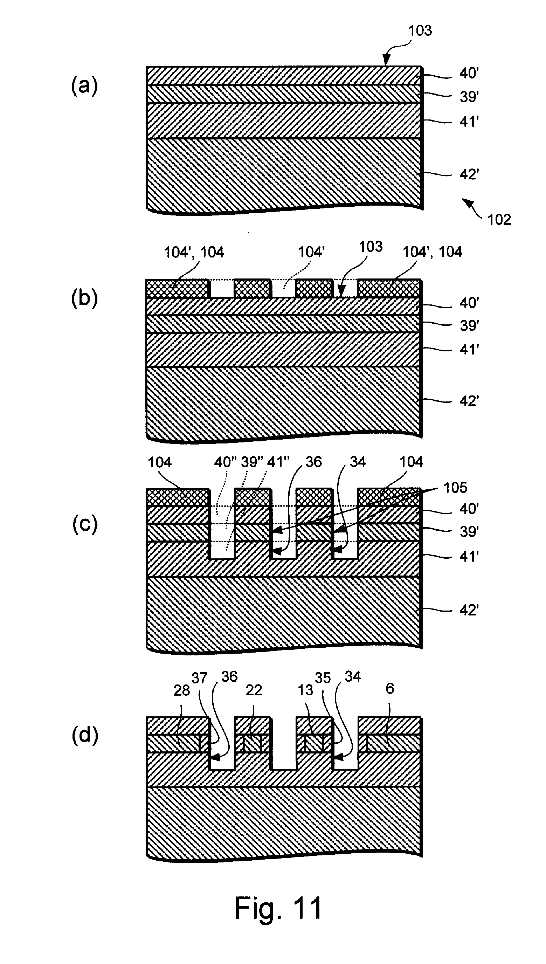

Referring to Figures 11a to 11d, a method of fabricating the device 1 shown in Figure 1 will now be described.

A silicon-on-insulator wafer (not shown) is formed by ion-implanting oxygen into a silicon substrate and annealing so as to form a buried silicon layer. Phosphorous ions are ion-implanted into the buried silicon layer and annealed so as to form a doped, buried silicon layer. The corresponding layer structure is shown in Figure 11a.

As shown in Figure 11a, a layer structure 102 of the silicon-on-insulator wafer (not shown) includes an n-type polycrystalline silicon layer 39' buried under a capping silicon dioxide layer 40' and separated by an isolation silicon dioxide layer 41' from a silicon substrate 42'. The silicon layer 39' has a thickness of 35 nm and an impurity doping density is $2.9 \times 10^{19} \text{cm}^{-3}$. The capping layer 40' has a thickness of 20 nm and the isolation layer 41' has a thickness of 400 nm.

The wafer (not shown) is divided into chips (not shown) and a chip (not shown) is processed in the following way.

Bond pads (not shown) and on-chip connecting leads (not shown) formed of chromium and gold are defined on an upper surface 103 using conventional techniques such as optical lithography, thermal evaporation and lift-off.

A layer of polymethylmethacrylate (PMMA) 104' is applied to the upper surface 103. The PMMA layer 104' is patterned using a scanning electron beam (not shown) and developed using a mixture of methyl isobutyl ketone (MIBK) and isopropanol alcohol (IPA) to leave a patterned layer PMMA layer 104. The corresponding layer structure after patterning is shown in Figure 11b.

Reactive ion etching (RIE) using carbon tetrafluoride ($CF_4$) as a feed gas is used to etch through and remove portions 39", 40" of the silicon layer 39' and capping layer 40' and to etch into and remove portions 41" of the isolation layer 41' leaving sidewalls 34, 36. The corresponding layer structure after etching is shown in Figure 11c.

The patterned layer PMMA layer 104 is removed using acetone and the chip is cleaned.

Low-temperature oxidation, at 900 °C in dry oxygen, is used to covert exposed regions 105 of the silicon layer 40', adjacent to the sidewalls 34, 36, into corresponding regions 35, 37 of silicon dioxide and thereby defining, for example, silicon gate regions 6, 28 and silicon quantum dot regions 13, 22. The corresponding layer structure after oxidation is shown in Figure 11d.

*Alternative device layout*

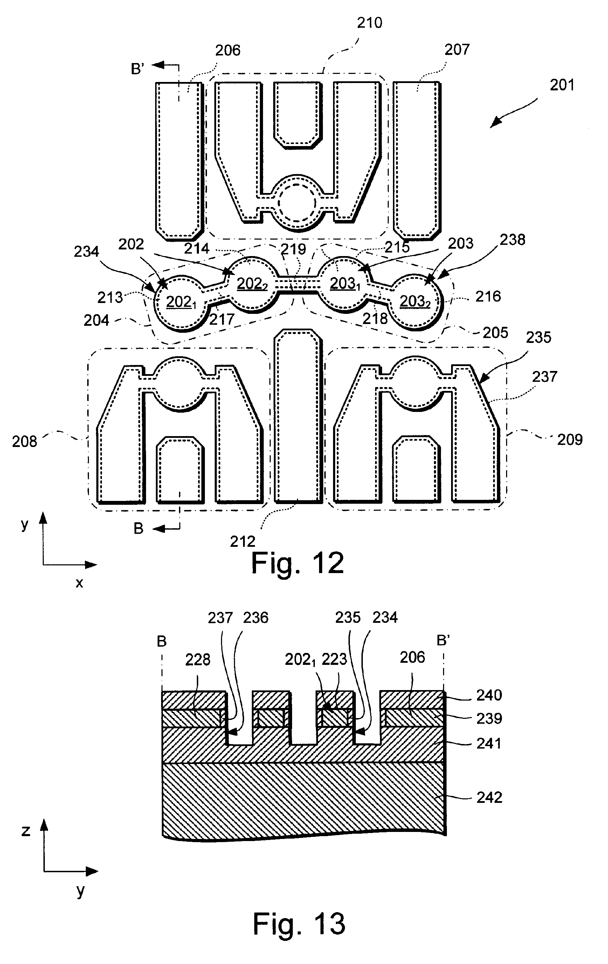

Referring to Figure 12, a second embodiment of a quantum dot device 201 according to the present invention is shown. The device 201 is similar to the device 1 described earlier and so will only be briefly described here.

The device 201 includes first and second double quantum dots 202, 203 for defining first and second qubits 204, 205 respectively.

The device 201 includes gates 206, 207 for applying respective electric fields to a left-hand quantum dot $202_1$ of the first double quantum dot 202 and a right-hand quantum dot $203_2$ of the second double quantum dot 203 so as to adjust electrochemical potentials thereof.

The device 201 also includes first and second single-electron transistors 208, 209 for measuring charge on the left-hand quantum dot $202_1$ of the first double quantum dot 202 and on the right-hand quantum dot $203_2$ of the second double quantum dot 203 respectively.

The device 201 also includes a third single-electron transistor 210 for measuring charge on the right-hand quantum dot $202_2$ of the first double quantum dot 202 and on the left-hand quantum dot $203_1$ of the second double quantum dot 203.

The device 201 further includes an additional gate 212 for applying an electric field to the double quantum dots 202, 203 so as to adjust electrochemical potentials thereof. The additional gate 212 can be used to compensate for cross talk between the first double quantum dot 202 and the second single-electron transistor 209 and between the second double quantum dot 203 and the first single-electron transistor 208.

The double quantum dots 202, 203 are formed in regions 213, 214, 215, 216 of n-type polycrystalline silicon. For each double quantum dot 202, 203, first and second coupling regions 217, 218 respectively connect the n-type polycrystalline regions 213, 214, 215, 216, thereby coupling the quantum dots $202_1$, $202_2$ $203_1$, $203_2$ so as to form the double quantum dot 202, 203.

A third coupling region 219 also couples the double quantum dots 202, 203 such that the quantum dots $202_1$, $202_2$, $203_1$, $203_2$ form a chain.

The device 201 is defined by etched sidewalls 234, 235 and silicon dioxide regions 236, 237. The quantum dot forming regions 213, 214, 215, 216 and the coupling regions 217, 218, 219 are bounded by a silicon dioxide region 236 running along etched sidewall 235 which defines a mesa 238. Likewise, the gates 206, 207, 212 and single electron transistors 208, 209, 210 include silicon dioxide regions 237 running along etched sidewalls 235.

Referring also to Figure 13, the device 201 is formed in an etched layer 239 of n-type polycrystalline silicon. The n-type polycrystalline silicon layer 239 is protected by an etched capping layer 240 of silicon dioxide and overlies a partially etched isolation layer 241 of silicon dioxide. The layers 239, 240, 241 are provided on a silicon substrate 242.

*Higher number qubit devices*

The devices 1, 201 described earlier may each provide two charge qubits. However, further coupling regions, in particular bridge coupling regions, allow devices (and parts of devices) to be connected together so as to form more complex devices having more than two charge qubits.

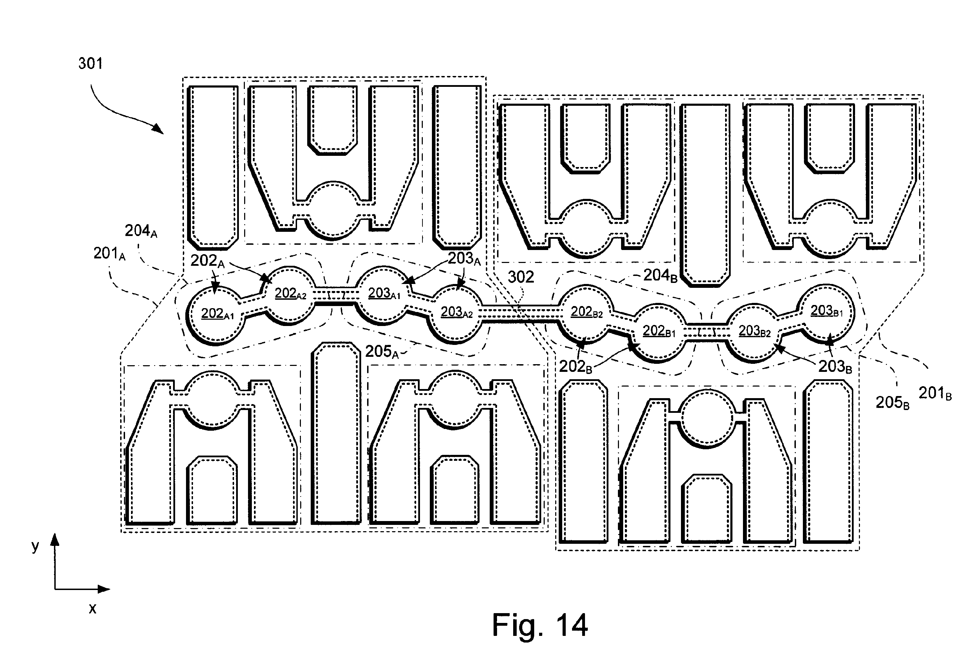

Referring to Figure 14, a third embodiment of a device 301 for quantum computing according to the present invention is shown.

The device 301 includes first and second devices $201_A$, $201_B$ substantially the same as the device 201 described earlier. The second device $201_B$ is rotated through 180 degrees on the surface of the chip, i.e. in the x-y plane, with respect to the first device $201_A$.

The first device $201_A$ includes first and second double quantum dots $202_A$, $203_A$ for defining first and second qubits $204_A$, $205_A$ respectively. Each double quantum dot $202_A$, $203_A$ includes first and second quantum dots $202_{A1}$,

$202_{A2}$, $203_{A1}$, $203_{A2}$. Likewise, the second device $201_B$ includes first and second double quantum dots $202_B$, $203_B$ for defining first and second qubits $204_B$, $205_B$ respectively. Each double quantum dot $202_B$, $203_B$ includes first and second quantum dots $202_{B1}$, $202_{B2}$, $203_{B1}$, $203_{B2}$.

The device 301 includes an additional bridge 302 for bridge coupling the qubits $204_A$, $205_A$ of the first device $201_A$ with the qubits $204_A$, $205_A$ of the second device $201_B$.

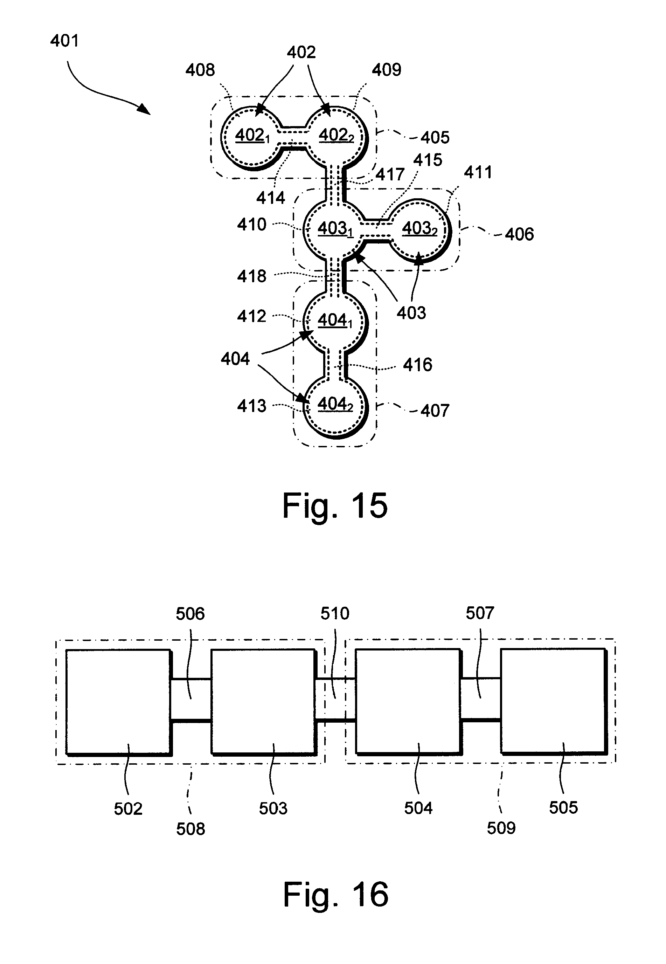

Referring to Figure 15, a part 401 of a fourth embodiment of a device (not shown) for quantum computing according to the present invention is shown. The device (not shown) is formed substantially in the same way as the devices 1, 201 described earlier.

The device includes first, second and third double quantum dots 402, 403, 404 for defining first, second and third qubits 405, 406, 407 respectively. Each double quantum dot 402, 403, 404 includes first and second quantum dots $402_1$, $402_2$ $403_1$, $403_2$, $404_1$, $404_2$.

The double quantum dots 402, 403, 404 are formed in regions 408, 409, 410, 411, 412, 413 of n-type polycrystalline silicon. For each double quantum dot 402, 403, 404, an n-type polycrystalline silicon constriction 414, 415, 416 connects the regions 408, 409, 410, 411, 412, 413, thereby coupling the quantum dots $402_1$, $402_2$, $403_1$, $403_2$, $404_1$, $404_2$ so as to form the double quantum dots 402, 403, 404.

First and second n-type polycrystalline silicon bridges 417, 418 connect the first and second double quantum dots 402, 403 and the second and third double quantum dots 403, 404 respectively.

The part of the device 401 shows that a two-dimensional arrangement of qubits can be used as opposed to the one-dimensional qubit arrangements provided by devices 201, 301 described earlier.

*Simulation*

Referring to Figure 16, a model 501 of the device 1 is shown. The model 501 is used for simulating resonant coupling.

The model 501 includes first, second, third and fourth quantum dots 502, 503, 504, 505 arranged in a linear chain. The first and second quantum dots 502, 503 are connected by a first coupling region 506 and the third and fourth quantum dots 504, 505 are connected by a second coupling region 507, thereby providing first and second charge qubits 508, 509. The first and second charge qubits 508, 509 are coupled by a third coupling region 510. The quantum dots 502, 503, 504, 505 and coupling regions 506, 507, 508 are square in plan view having sides of 25 and 5 nm respectively.

Simulation involves considering single particle states of carriers in the model 501. In particular, the simulation involves calculating energies and wavefunctions of an electron by a solving the Schrödinger equation using a plane-wave expansion method. Details of the method used to solve the Schrödinger equation can be found in "Theory of the electronic structure of GaN/A1N hexagonal quantum dots", A. D. Andreev and E. P. O'Reilly, Phys.Rev. B, v. 62, 15851-15870 (2000) and "Nearly free carrier model for calculating the carrier spectrum in heterostructures", A.D. Andreev, R.A. Suris ,Semiconductors, v. 30, N. 3, pp. 285-292 (1996).

To characterise coupling of the qubits 508, 509 for an *N*-th energy level of the system, a coupling degree $S_{ij}$ between an *i*-th dot and an *j*-th dot is specified, where *i,j* = 1, 2, 3, 4 (i.e. first, second, third and fourth quantum dots 502, 503, 504, 505 respectively):

$$S_{ij}(N)=4P_i(N)P_j(N), \qquad\qquad (1)$$

where:

$$P_i = \int\limits_{\substack{i-th \\ QD}} |\Psi_N(\mathbf{r})| d^3 r \qquad\qquad (2)$$

such that $P_i$ is the probability of finding the electron in the i-th quantum dot, $\Psi_N(\mathbf{r})$ is the wavefunction of the electron state corresponding to the level number N of the system, vector r gives the position in real space. The coupling degree defined in equation (1) above can have positive values between 0 and 1. Probabilities $P_i$ are normalised and so if two dots are totally coupled, then $P_i=P_j=1/2$ and $S_{ij}=1$ and if two dots are uncoupled, then $S_{ij}=0$.

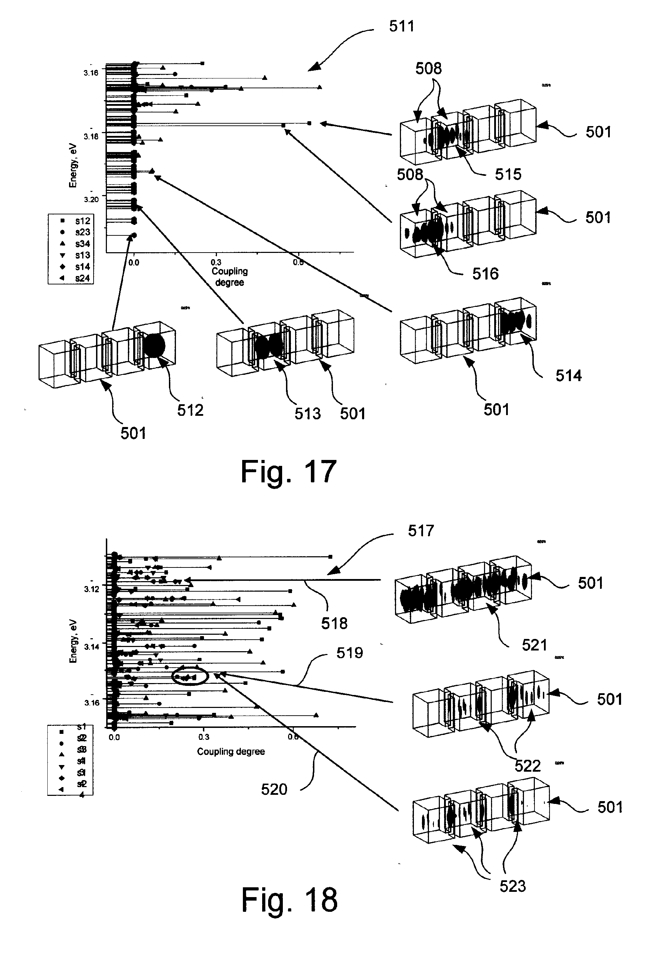

Referring to Figure 17, a plot 511 of coupling degree $S_{ij}$ between an i-th dot and an j-th dot against energy for $1 \le N \le 200$ for a first range of energies is shown.

The plot 511 shows that $S_{ij}(N)=0$ for all $i$ and $j$ for uncoupled states which are localised in individual quantum dots 502, 503, 504, 505 and that $S_{ij}(N) > 0$ for coupled molecular states, such as for $i = 1$ and $j = 2$ (i.e. for the first qubit 508) and for $i = 3$ and $j = 4$ (i.e. for the second qubit 509).

Figure 17 also illustrates three-dimensional plots 512, 513, 514 of surfaces of constant probability density ($|\Psi_N(\mathbf{r})|^2$) for an electron within the system 501 for N = 1, N = 6 and N= 23 respectively and for which states are uncoupled. The surfaces 512, 513, 514 are 25% of a maximum value.

Figure 17 also shows three-dimensional plots 515, 516 of surfaces of constant probability density for N = 54 and N= 51 and for which states are coupled within the first qubit 508. Again, the surfaces 515, 516 are 25% of a maximum value.

Referring to Figure 18, a plot 517 of coupling degree $S_{ij}$ between an i-th dot and a j-th dot against energy for $1 \le N \le 200$ for a second range of energies is shown.

The plot 517 shows resonantly coupled states 518, 519, 520 and states which, even though they are close in energy, are still not coupled. Thus, in a resonant or "molecular" state, the electron can be found with finite probability across all four quantum dots 502, 503, 504, 505.

Figure 18 illustrates three-dimensional plots 521, 522, 523 of surfaces of constant probability density for N= 117, N = 107 and N = 106 and which are coupled states of two qubits 508, 509. The surfaces 521, 522, 523 are 25% of a maximum value.

The appearance of resonant coupled states 518, 519, 520 can be controlled by changing parameters of the bridge 510, such as the geometrical size of the bridge 510 and/or the material from which the bridge 510 is formed.

In the model 501, each quantum dot 502, 503, 504, 505 is square in plan view. The devices described earlier may be modified so that semiconductor regions providing the quantum dots are not circular in plan view, but square or rectangular. This has an advantage that oxidation can be better controlled in the (001) directions.

It will be appreciated that many modifications may be made to the embodiments hereinbefore described. Different materials, layer thicknesses and device configurations may be used. For example, silicon may be doped to a different concentration. Other n-type impurities, such as arsenic, can be used. Silicon may be doped with a p-type impurity, such as boron. Other semiconducting and insulating materials can be used. For example, other silicon-based semiconducting materials, such as silicon-germanium, may be used. Non-silicon-based semiconducting materials, such as gallium arsenide (GaAs), may be used. Binary or tertiary alloys, such as gallium arsenide (GaAs), aluminium gallium arsenide (AlGaAs), indium arsenide (InAs) and gallium indium arsenide (AlInAs), may be used. In particular, devices may be formed in an GaAs/AlGaAs heterostructure providing a 2-dimensional electron gas or in a $\delta$-doped layer in GaAs. Dilute magnetic semiconductors (DMSs), such as GaMnAs, may be used. The semiconductor materials may be undoped or doped with an impurity to a concentration less than $1 \times 10^{19} \mathrm{cm}^{-3}$.

Alternative voltage configurations may be applied to the gates to achieve coupling and decoupling can be used. For example, qubits may be coupled by applying appropriate biases to a combination of gates different to those described earlier. Negative biases may be used. The devices need not be electrically controlled using gates, but can be optically controlled.

The device can be any type of multiple-qubit device.

**Claims**

**1.** A multiple-quantum dot device comprising:

a first system for providing at least one quantum dot;
a second system for providing at least one quantum dot; and

**characterised by** a bridge between the first and second systems for providing at least one zero- or one-dimensional state freely extending from the first system to the second system.

**2.** A device according to claim 1, wherein the first system is for providing a first quantum dot and the second system is for providing a second quantum dot.

**3.** A device according to claim 1 or 2, wherein the first system is for defining a coupled quantum dot and the second system is for defining a second coupled quantum dot.

**4.** A device according to any preceding claim, wherein the first system is for defining a plurality of quantum dots and the second system is for defining a plurality of quantum dots.

**5.** A device according to any preceding claim, wherein the bridge is for providing a set of zero-dimensional states.

**6.** A device according to any preceding claim, wherein the bridge provides a tunnel barrier to at least some of the zero-dimensional states lying below a Fermi level in the first system.

**7.** A device according to any preceding claim, wherein the first system comprises a first semiconductor region and the second system comprises a second semiconductor region.

**8.** A device according to any preceding claim, wherein the bridge comprises a third semiconductor region.

**9.** A device according to claim 7 or 8, the regions are provided in a layer of semiconductor material.

**10.** A device according to any one of claims 7 to 9, wherein the semiconductor regions comprise silicon.

**11.** A device according to any one of claims 7 to 10, wherein the semiconductor regions are doped with an impurity.

**12.** A device according to claim 11, wherein the semiconductor regions are doped with an impurity to a concentration greater than $1 \times 10^{19} cm^{-3}$.

**13.** A device according to any preceding claim, further comprising:

at least one electrometer for detecting charge in the first system.

**14.** A device according to any preceding claim, further comprising:

at least one gate for applying an electric field to at least part of the first system.

**15.** A device according to any preceding claim, comprising an elongate bar of semiconductor material of thickness less than 50 nm, the elongate bar having alternating wide and narrow sections, the wide sections being less than 30 nm wide and the narrow sections being less than 10 nm wide.

**16.** A device according to claim 15, wherein the elongate bar of semiconductor material of thickness less than 30 nm.

**17.** A device according to claim 15 or 16, wherein the wide sections are between 10 and 30 nm wide and the narrow sections are between 1 and 10 nm wide.

**18.** A multiple-quantum dot device comprising an elongate bar of semiconductor material of thickness less than 50 nm, the elongate bar having alternating wide and narrow sections, the wide sections being less than 30 nm long and less than 30 nm wide and the narrow sections being less than 10 nm long and less than 10 nm wide, the elongate bar including first and second wide sections connected by a first narrow section for defining a first double quantum dot and third and fourth wide sections connected by a second narrow section for defining a second double quantum dot, wherein the second and third wide sections are connected by a third narrow section for coupling the first and second quantum dots.

**19.** A device according to claim 18, wherein the semiconductor is silicon.

**20.** A device according to any preceding claim, for quantum computing.

**21.** Apparatus comprising:

a multiple quantum dot device according to any preceding claim; and
a refrigerator arranged to cool the device.

**22.** Apparatus according to claim 21, wherein the refrigerator arranged to cool the device to or below 77 Kelvin, preferably to or below 4.2 Kelvin.

**23.** Apparatus according to claim 21 or 22, wherein the refrigerator is for cooling the device to a temperature of the order of 1 or 10 milliKelvin.

**24.** Apparatus according to any one of claims 12 to 23, wherein the device comprises a gate for applying an electric field to at least part of the first system and the apparatus further comprises circuitry configured to selectively apply a signal to the gate for applying an electric field to at least part of the first system so as to cause charge redistribution between the first and second system.

**23.** A method of fabricating a multiple-quantum dot device, the method comprising:

providing a first system for providing at least one quantum dot;
providing a second system for providing at least one quantum dot; and
providing a bridge between the first and second systems for providing at least one zero- or one-dimensional state freely extending from the first system to the second system.

**24.** A method of operating a multiple-quantum dot device comprising a first system for providing at least one quantum dot, a second system for providing at least one quantum dot and a bridge between the first and second systems for providing at least one zero- or one-dimensional state freely extending from the first system to the second system, the method comprising:

applying an applying an electric field to at least part of the first system so as to cause charge redistribution between the first and second system.

Fig. 1

Fig. 2

EP 1 860 600 A1

Fig. 3

(a)

(b)

Fig. 4

Fig. 5

Fig. 6

Fig. 7

Fig. 8

Fig. 9

Fig. 10

(a)

103
40'
39'
41'
42'
102

(b)

104', 104      104'      103      104', 104
40'
39'
41'
42'

(c)

104      40" 39" 41"   36      34      104
105
40'
39'
41'
42'

(d)

28  37  36      22      13  35  34      6

# Fig. 11

Fig. 12

Fig. 13

Fig. 14

EP 1 860 600 A1

401

408    402    409

405

417    415

414    411

410    403₁    403₂    406

418    403

412    404₁

404    416

413    404₂    407

## Fig. 15

506    510    507

502    503    504    505

508    509

## Fig. 16

Fig. 17

Fig. 18

**EP 1 860 600 A1**

## EUROPEAN SEARCH REPORT

European Patent
Office

Application Number

EP 06 11 4602

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AKIS R ET AL: "Ballistic transport and scarring effects in coupled quantum dots" PHYSICAL REVIEW B (CONDENSED MATTER) APS THROUGH AIP USA, vol. 59, no. 11, 15 March 1999 (1999-03-15), pages 7529-7536, XP002419642 ISSN: 0163-1829 | 1-6,18, 25,26 | INV. G06N1/00 |
| Y | * the whole document * | 7-17, 19-24 | |
| D,Y | EP 1 262 911 A (HITACHI EUROP LTD [GB]) 4 December 2002 (2002-12-04) * the whole document * | 7-17, 19-24 | |
| A | US 2005/001209 A1 (HILTON JEREMY P [CA] ET AL) 6 January 2005 (2005-01-06) * paragraphs [0080] - [0082]; figures 5A,5B * | 1-26 | |
| A | SOUMA S ET AL: "Molecular like states in coupled magnetic quantum dots" AIP CONFERENCE PROCEEDINGS AIP USA, 27TH INTERNATIONAL CONFERENCE ON THE PHYSICS OF SEMICONDUCTORS, ICPS-27, 26-30 JULY 2004, FLAGSTAFF , AZ,USA, no. 772, 2005, pages 735-736, XP002419640 ISSN: 0094-243X * the whole document * | 1-26 | TECHNICAL FIELDS SEARCHED (IPC) G06N |
| A | CAIN P A ET AL: "Hole transport through single and double SiGe quantum dots" APPLIED PHYSICS LETTERS AIP USA, vol. 77, no. 21, 20 November 2000 (2000-11-20), pages 3415-3417, XP002419641 ISSN: 0003-6951 * the whole document * | 1-26 | |

The present search report has been drawn up for all claims

| Place of search | Date of completion of the search | Examiner |
|---|---|---|
| The Hague | 13 February 2007 | Schenkels, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

24

**EP 1 860 600 A1**

**ANNEX TO THE EUROPEAN SEARCH REPORT
ON EUROPEAN PATENT APPLICATION NO.**                    EP 06 11 4602

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2007

| Patent document cited in search report | | Publication date | Patent family member(s) | | Publication date |
|---|---|---|---|---|---|
| EP 1262911 | A | 04-12-2002 | JP | 2003086788 A | 20-03-2003 |
|  |  |  | US | 2002190249 A1 | 19-12-2002 |
| US 2005001209 | A1 | 06-01-2005 | NONE | | |

EPO FORM P0459

For more details about this annex : see Official Journal of the European Patent Office, No. 12/82

**25**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1262911 A

### Non-patent literature cited in the description

- **J. GORMAN ; D. G. HASKO ; D. A. WILLIAMS.** Charge-qubit operation of an isolated double quantum dot. *Physical Review Letters,* 2005, vol. 95, 090502
- **T. HAYASHI ; T. FUJISAWA ; H. D. CHEONG ; Y. H. JEONG ; Y. HIRAYAMA.** Coherent manipulation of electronic states in a double quantum dot. *Physical Review Letters,* 2003, vol. 91, 226804
- **A. D. ANDREEV ; E. P. O'REILLY.** Theory of the electronic structure of GaN/A1N hexagonal quantum dots. *Phys.Rev. B,* 2000, vol. 62, 15851-15870
- **A.D. ANDREEV ; R.A. SURIS.** Nearly free carrier model for calculating the carrier spectrum in heterostructures. *Semiconductors,* 1996, vol. 30 (3), 285-292